# EUROPEAN PATENT APPLICATION

(11) **EP 4 199 030 A1**
(43) Date of publication of application: **21.06.2023**
(21) Application number: 21214852.2
(22) Date of filing: 15.12.2021
(51) Int. Cl.: H01J 37/22, H01J 37/20

(54) **THERMAL DRIFT CORRECTION BASED ON THERMAL MODELING**

(71) Applicant: FEI Company, Hillsboro, OR 97124 (US)
(72) Inventor: van Leeuwen, Hugo, 5602 BS Eindhoven (NL); Verschueren, Edwin, 5602 BS Eindhoven (NL); Lamers, Ronald, 5602 BS Eindhoven (NL); van den Oetelaar, Twan, 5602 BS Eindhoven (NL); Verheijen, Martin, 5602 BS Eindhoven (NL); van Wensveen, Marcel, 5602 BS Eindhoven (NL)
(74) Representative: Stellbrink & Partner Patentanwälte mbB

(57) **Abstract**

The present invention relates to a method to reduce drift of a sample and/or its image in a microscopy system, wherein the method comprises determining an expected thermal drift of the sample, and compensating for the drift of the sample and/or its image based upon the expected thermal drift. The present invention also relates to a corresponding microscopy system and a computer program product to perform the method according to the present invention.

## Description

### Field

The present invention relates generally to the field of microscopy. More particularly, it relates to a method for correcting for the drift of a sample or its image in a microscopy system, particularly a charged particle beam microscopy system.

### Background

Charged particle beam microscopy systems are widely used for precise observation, characterization, and fabrication of micro- or nano-scale systems. Both electron and ion beam microscopes offer higher resolution than conventional optical microscopy systems, owing to the shorter wavelength of charged particles. Charged particle beam microscopes routinely allow resolutions ranging from tens of pm to hundreds of nm. However, this finer resolution comes with its own set of challenges.

One particular challenge is that of drifting of the image. While in a typical optical microscope, owing to its coarser resolution, drifts of the order of tens of pm may not be important, they present a significant challenge affecting the overall resolution that may be achieved with a charged particle beam microscope. For example, in an optical microscope used for imaging the resolution may be 500 nm corresponding to a wavelength of the optical beam used for imaging. In this case, a drift of the image of about 500 pm may not be significant as such a variation lies below the resolution limit of the microscope itself. However, an electron microscope may have a resolution of 100 pm in which case a drift of 500 pm may significantly affect imaging.

Image drift may be a result of drifting of the sample that itself may be an effect of various causes. Potential causes of this drift include mechanical instability of a column or sample support (that may also be called a sample holder), thermal expansion and contraction of different components of the microscope (that may be called a thermal drift), accumulation of charges in the column, and mechanical disturbances, among others. The present technology is directed to image drift resulting from thermal expansion and contraction of different components.

Thermal expansion and contraction effects may typically be in the range of tens of nm. They may thus not be significant for optical microscopes. Efforts to address these have ranged from completely software-based methods involving processing of images of the sample to correct for drift to completely hardware-based methods involving use of materials with, for example, a low coefficient of thermal expansion in the design of different components of the microscope. These methods may help reduce the effects of thermal drift on the final images but may require a complex setup or may be inefficient with regard to time. Additionally, it may take a significant length of time for the sample to settle into a stable position if thermal drift is not corrected for.

### Summary

The present invention seeks to overcome or at least alleviate the shortcomings and disadvantages of the prior art. More particularly, it is an object of the present invention to provide an improved method, system and computer program product for correcting for thermal drift in microscopy systems, particularly in microscopy systems employing charged particle beams.

According to a first aspect, the present invention relates to a method to reduce drift of a sample and/or its image in a microscopy system, wherein the method comprises determining an expected thermal drift of the sample, and compensating for the drift of the sample and/or its image based upon the expected thermal drift. The compensation may be effected as feedback, or feedforward as will be described in embodiments further.

The expected thermal drift may be determined, at least in part, by means of a thermal model configured to at least receive some input and produce some output. The thermal model may be based on physical principles and may comprise parameter(s) that may, for example, be updated based on the feedback described above. A physics-based model may be advantageous as the impact of different parameters, such as, for example, a coefficient of thermal expansion of a sample holder on the thermal drift may be determined. If, for example, the impact is found to be significant, the material composition of the sample holder may be varied or heat exchange with the sample holder be appropriately reduced.

The microscopy system may comprise a plurality of thermal elements configured for heat transfer and/or heat exchange, and wherein the thermal model is based, at least in part, on the heat flow through, and/or between, any of the plurality of thermal elements. The thermal elements may comprise, for example, motors configured to drive a sample holder, chemical reactions that may be studied in-situ (and heat generated by them), gas flux that may be used to prepare/analyze the sample, among other thermal elements. Generally, the thermal elements may comprise any source or sink of heat that may interact with components of the microscopy system and lead to a thermal drift of the sample and/or its image. In this respect, it may be appreciated that, for example, a gas flux introduced from outside the microscopy system is also to be considered a thermal element of the microscopy system. Other examples of different scenarios where such heat exchange with components of the microscopy system may take place comprise heat dissipation in flexures (that may be employed to move the sample holder), in-situ experiments where the sample may be stimulated with light, or electricity among other stimuli, MEMS heaters for sample heating, heat dissipated in the sample by the beam. Note that this represents only an exemplary list of scenarios where embodiments of the present technology may be of advantage, but should in no way be construed to limit the scope of the present invention.

The thermal model may be based on thermal properties of any of the plurality of thermal elements.

For example, such properties may comprise any of a thermal conductance, temperature, coefficient of thermal expansion, rate of heat flow, and thermal emissivity, among others. Thus, for example, the thermal model may be used to determine heat flow between the sample and its environment that may be used to determine the expected thermal drift resulting from thermal interaction of the sample with its environment.

The expected thermal drift may be determined, at least in part, by means of an artificial intelligence-based model. An artificial intelligence-based model may allow determination of the expected thermal drift without a precise modeling of the thermal elements and heat exchanges between them. This may be of advantage, for example, in cases where the number of thermal elements is large and a precise model may be computationally intensive.

The plurality of thermal elements may comprise a sample holder configured to hold the sample.

Determining an expected thermal drift of the sample may comprise determining an expected thermal drift of the sample holder. The thermal drift of the sample holder may be significantly identical to the thermal drift of the sample. In particular, the sample holder may comprise a tip over which the sample may be positioned. In this case, the thermal drift of the tip of the sample holder may be significantly identical to the thermal drift of the sample.

An output of the thermal model may be the expected thermal drift of the sample holder.

The microscopy system may comprise at least one property sensor configured to measure at least one defined property of at least one defined location in the microscopy system. The property sensor may be any sensor and may depend on the property to be measured. For example, it may be a temperature sensor if a temperature is to be measured. Or, it may be an ammeter if a current is to be measured. Similarly, if a power supplied to a motor of the stage assembly is to be measured, for example, an appropriate power sensor may be provided. The property to be measured may itself depend on the input to the thermal or artificial intelligence-based model described above. For example, in some embodiments a temperature may be input to the model, while in other embodiments, a power supplied to a motor that may be configured to move the sample may be input to the model.

The at least one property sensor may comprise a plurality of property sensors.

The plurality of property sensors may be configured to measure at least one defined property at a plurality of defined locations. For example, the microscopy system may comprise a plurality of temperature sensors that each measure the temperature at different locations in the microscopy system.

The at least one defined property may comprise a plurality of defined properties. For example, the properties may comprise a temperature and a power. At different locations of the microscopy system different sensors may be used to measure either or both of these properties. For example, as described above, a power supplied to a motor may be measured by using a sensor configured to measure such power. Additionally, a temperature sensor may also be used to measure the temperature of the motor. Further additionally, a plurality of other temperature sensors may be used at other locations in the microscopy system.

The at least one defined property may comprise a temperature and the at least one property sensor may comprise a temperature sensor.

The at least one temperature sensor may comprise a plurality of temperature sensors configured to measure the temperature at a plurality of defined locations in the microscopy system.

An input to the thermal model may comprise a temperature measured by at least one temperature sensor. The thermal model may be configured to use the measured temperature at exactly one location, for example, to then determine the expected thermal drift of the sample based on, for example, a heat flow network of the different thermal elements in the microscopy system. This may be of advantage in providing a simple microscopy system that may only need to be supplemented with exactly one temperature sensor measuring the temperature at a defined location.

An input to the thermal model may comprise a plurality of temperatures measured by a plurality of temperature sensors. This may be of advantage in improving the robustness and accuracy of the thermal model.

An input to the thermal model may comprise the difference of at least one pair of temperatures from the plurality of temperatures measured by the plurality of temperature sensors. This may further improve the robustness and accuracy of the model as similar temperature fluctuations occurring at a pair of temperature sensors may be cancelled out.

An input to the thermal model may comprise the at least one defined property as described above.

The at least one defined location may comprise a location on the sample holder.

The plurality of defined locations may comprise a plurality of locations on the sample holder.

The microscopy system may be configured to direct a beam of particles at the sample.

The beam of particles may comprise charged particles. For example, the beam may comprise electrons and the microscopy system may comprise an electron microscope such as a transmission electron microscope, a scanning electron microscope, or a scanning transmission electron microscope. Alternatively, the beam may comprise positively charged ions and the microscopy system may comprise a focused ion beam microscope, for example.

The plurality of thermal elements may comprise a stage configured to position the sample under the beam of particles.

The stage may be configured to move the sample holder to position the sample under the beam of particles.

The plurality of thermal elements may comprise a connection between the stage and the sample holder. This may be of advantage in allowing consideration of heat transfer between the stage and the sample holder to be included in the model.

The at least one defined location as described above may comprise a location on the stage.

The plurality of defined locations as described above may comprise a plurality of locations on the stage.

The microscopy system may be configured to be operated in an environment, and wherein an input to the thermal model may comprise a temperature of the environment.

The microscopy system may comprise a vacuum chamber configured to house the sample, and wherein the plurality of thermal elements may comprise the vacuum chamber.

The at least one defined location may comprise a location in the vacuum chamber.

The plurality of defined locations may comprise a plurality of locations in the vacuum chamber.

The microscopy system may comprise at least one motor configured to drive the stage to position the sample under the beam of particles.

The at least one motor may comprise a plurality of motors, such as three motors, configured to drive the stage.

The plurality of thermal elements may comprise any of the at least one motor.

An input to the thermal model may comprise a power and/or voltage and/or current supplied to at least one motor. The input current/voltage may be used to determine the power supplied to the motor that may in turn be used to determine a heat dissipated by the motor.

A result of at least one motor driving the stage may be dissipation of heat generated by the at least one motor.

An input to the thermal model may comprise a magnitude and/or rate of heat dissipated by the at least one motor.

The method may comprise using the thermal model to predict the temperature measured by the at least one temperature sensor and comparing it with the input temperature measured by the at least one temperature sensor.

The method may further comprise updating the thermal model based on the difference between the predicted and input temperature corresponding to the at least one temperature sensor. Thus, this may comprise a feedback mode that may be used to refine the determination of the expected thermal drift based on refinements in the model.

The thermal model may comprise a first sub-module configured to determine an expected temperature at a defined location in the microscopy system, and a second sub-module configured to determine the expected thermal drift of the sample.

An input to the second sub-module may be the expected temperature determined by the first sub-module.

At least one of the at least one temperature sensor may be configured to measure the temperature at a defined location significantly identical to the defined location for which the first sub-module is configured to determine the expected temperature. Together with the feedback mode described above, this may help improve the determination of the expected thermal drift of the sample as any noise in the measured temperature that is fed back into the model may be suppressed by using the determined temperature.

The method may further comprise updating the first sub-module based on a difference between the temperature measured and the temperature determined by the first sub-module at the defined location. For example, the first sub-module may be configured to apply larger corrections to parameters if the difference between the measured and determined temperature is large.

The power and/or voltage and/or current supplied to at least one motor may be input to the first sub-module of the thermal model.

The temperature of the environment may be input to the first sub-module of the thermal model.

Compensating for the drift of the sample and/or its image based on the expected thermal drift may comprise controlling a position of the sample based on the expected thermal drift. For example, if the expected thermal drift is positive (with respect to some co-ordinate system), the microscopy system may be configured to position the sample to a position substantially identical to a target position minus the expected thermal drift.

The microscopy system may comprise a control unit configured to position the sample by controlling the at least one motor. The control unit may be configured to control the motor based on, for example, a difference between a target position of the sample and a sensed position of the sample.

The control unit may be configured to send data to the at least one motor. The data may comprise, for example, an amount of translation that the motor may effect.

The at least one motor may be configured to receive data from the control unit, and based thereon, to position the sample.

The microscopy system may further comprise a position sensor configured to sense the position of the sample.

The position sensor may be configured to send data relating to the sensed position of the sample to the control unit. As described above, this may help to control the motor driving the position of the sample.

The control unit may be configured to receive data relating to the sensed position of the sample from the position sensor.

The control unit may be further configured to position the sample based on the sensed position of the sample and a target position.

The microscopy system may further comprise an inverse kinematics module configured to at least receive data relating to a position in a first co-ordinate system.

The inverse kinematics module may be further configured to send data relating to a position in a second co-ordinate system, wherein the first co-ordinate system is not identical to the second co-ordinate system.

The input to the inverse kinematics module may comprise the position of the sample as determined in the first co-ordinate system as a result of the expected thermal drift.

The output of the inverse kinematics module may comprise data relating to a translation of the stage in the second co-ordinate system to compensate for the expected thermal drift of the sample.

The method may further comprise the inverse kinematics module sending the data relating to translation of the stage to the control unit. Overall, the inverse kinematics module may thus be of advantage in configurations where the translations effected by the motors are not directed along the co-ordinate axes that may be used to locate the sample. For example, the co-ordinate axes along which the motors effect translations may be obtained by a rotation of the co-ordinate axes used to locate the sample by a defined angle.

The control unit may be configured for receiving the data relating to translation of the stage from the inverse kinematics module.

Compensating for the drift of the sample and/or its image based on an expected thermal drift of the sample may further comprise using an observed image of the sample as feedback to compensate for the drift of the sample and/or its image. This may be of further advantage as real-time information about the image may be used to correct for thermal drift. It may help in improving the efficiency of the method and allow for a faster approach to equilibrium around a target sample position.

The method may comprise using an image processing module to compensate for the drift of the sample and/or its image.

An input to the image processing module may comprise an image of the sample.

An output of the image processing module may comprise data relating to an observed position of the sample. The image processing module may thus be configured to carry out conversion from the pixel space of the image to the position space.

An input to the inverse kinematics module may further comprise data relating to the observed position of the sample.

The data relating to a translation of the stage may be based on the difference between the expected thermal drift of the sample and the observed drift of the sample.

The artificial-intelligence based model described above may comprise any of an artificial neural network, a random forest, a Gaussian process, a hidden Markov model, a state vector machine, or any other artificial intelligence model.

The expected thermal drift may be determined by the artificial intelligence-based model using, at least in part, supervised learning. For example, the artificial intelligence-based model may be trained by using experimental data of the measured thermal drift in response to, for example, the measured temperature at a defined location. Based on this data, a machine learning model may be trained to which the temperature measured at the defined location may be input. The output of the machine learning model may then be the expected thermal drift.

An output of the artificial intelligence-based model may comprise the expected thermal drift of the sample and/or its image.

An input to the artificial intelligence-based model may comprise the temperature measured by at least one of the at least one temperature sensors.

An input to the artificial intelligence-based model may comprise a power and/or voltage and/or current supplied to at least one motor.

An input to the thermal model may comprise data relating to humidity.

For example, such data may comprise the relative humidity of the microscopy system's environment, or the humidity around any of the thermal elements described above.

The method as described above may be implemented, at least in part, on a data processing unit.

According to a second aspect, the present invention relates to a microscopy system comprising a sample, wherein the microscopy system is configured to reduce drift of the sample and/or its image by determining an expected thermal drift of the sample, and compensating for the drift of the sample and/or its image based upon the expected thermal drift.

The microscopy system may comprise at least one temperature sensor configured to measure the temperature of at least one defined location in the microscopy system.

The at least one temperature sensor may comprise a plurality of temperature sensors configured to measure the temperature at a plurality of defined locations in the microscopy system.

The microscopy system may be configured to direct a beam of particles at the sample.

The beam of particles may comprise charged particles.

The plurality of thermal elements as described above may comprise a stage configured to position the sample under the beam of particles.

The microscopy system may comprise a vacuum chamber configured to house the sample, and wherein the plurality of thermal elements comprises the vacuum chamber.

The microscopy system may comprise at least one motor configured to drive the stage to position the sample under the beam of particles.

The microscopy system may comprise a control unit configured to position the sample by controlling the at least one motor.

The microscopy system may comprise a position sensor configured to sense a position of the sample.

The microscopy system may comprise a data processing unit configured to determine the expected thermal drift.

The thermal model may be configured to be run on the data processing unit as described above.

The artificial intelligence-based model may be configured to be run on the data processing unit.

The data processing unit may be configured to send data to the control unit described above.

The control unit may be configured to receive data from the data processing unit.

The microscopy system as described above may be configured to perform the method as described above.

According to a third aspect, the present invention relates to a computer program product comprising instructions, when run on a data processing unit of a microscopy system as described above, to perform the method as described above. The computer program product may, for example, comprise instructions to read a measured temperature from a temperature sensor, and then to carry out the determination of the expected thermal drift of the sample. It may allow changing any of the parameters characterizing thermal properties of the thermal elements described above, and adding/deleting any thermal elements.

Below method embodiments will be discussed. These are abbreviated by the letter'M' followed by a number. Whenever reference is herein made to method embodiments, these embodiments are meant.
M1. A method to reduce drift of a sample and/or its image in a microscopy system, wherein the method comprises determining an expected thermal drift of the sample, and
   compensating for the drift of the sample and/or its image based upon the expected thermal drift.
M2. The method according to the preceding embodiment, wherein the expected thermal drift is determined, at least in part, by means of a thermal model configured to at least receive some input and produce some output.
M3. The method according to the preceding embodiment, wherein the microscopy system comprises a plurality of thermal elements configured for heat transfer and/or heat exchange, and wherein the thermal model is based, at least in part, on the heat flow through, and/or between, any of the plurality of thermal elements.
M4. The method according to the preceding embodiment, wherein the thermal model is based on thermal properties of any of the plurality of thermal elements.
For example, such properties may comprise any of a thermal conductance, temperature, coefficient of thermal expansion, rate of heat flow, and thermal emissivity, among others.
M5. The method according to any of the preceding method embodiments, wherein the expected thermal drift is determined, at least in part, by means of an artificial intelligence-based model.
M6. The method according to any of the preceding method embodiments and with the features of embodiment M3, wherein the plurality of thermal elements comprises a sample holder configured to hold the sample.
M7. The method according to the preceding embodiment, wherein determining an expected thermal drift of the sample comprises determining an expected thermal drift of the sample holder.
M8. The method according to the preceding embodiment and with the features of embodiment M2, wherein an output of the thermal model is the expected thermal drift of the sample holder.
M9. The method according to any of the preceding method embodiments, wherein the microscopy system comprises at least one property sensor configured to measure at least one defined property of at least one defined location in the microscopy system.
M10. The method according to the preceding embodiment, wherein the at least one property sensor comprises a plurality of property sensors.
M11. The method according to the preceding embodiment, wherein the plurality of property sensors is configured to measure at least one defined property at a plurality of defined locations.
M12. The method according to the preceding embodiment, wherein the at least one defined property comprises a plurality of defined properties.
M13. The method according to any of the preceding method embodiments and with the features of embodiment M9, wherein the at least one defined property comprises a temperature and the at least one property sensor comprises a temperature sensor.
M14. The method according to the preceding embodiment, wherein the at least one temperature sensor comprises a plurality of temperature sensors configured to measure the temperature at a plurality of defined locations in the microscopy system.
M15. The method according to any of the 2 preceding embodiments and with the features of embodiment M2, wherein an input to the thermal model comprises a temperature measured by at least one temperature sensor.
M16. The method according to the preceding embodiment, wherein an input to the thermal model comprises a plurality of temperatures measured by a plurality of temperature sensors.
M17. The method according to the preceding embodiment, wherein an input to the thermal model comprises the difference of at least one pair of temperatures from the plurality of temperatures measured by the plurality of temperature sensors.
M18. The method according to any of the preceding method embodiments and with the features of embodiments M2, and M9, wherein an input to the thermal model comprises the at least one defined property.
M19. The method according to any of the preceding method embodiments and with the features of embodiments M6, and M9, wherein the at least one defined location comprises a location on the sample holder.
M20. The method according to any of the preceding method embodiments and with the features of embodiments M6, and M14, wherein the plurality of defined locations comprises a plurality of locations on the sample holder.
M21. The method according to any of the preceding method embodiments, wherein the microscopy system is configured to direct a beam of particles at the sample.
M22. The method according to the preceding embodiment, wherein the beam of particles comprises charged particles.
M23. The method according to any of the 2 preceding embodiments and with the features of embodiment M3, wherein the plurality of thermal elements comprises a stage configured to position the sample under the beam of particles.
M24. The method according to the preceding embodiment and with the features of embodiment M6, wherein the stage is configured to move the sample holder to position the sample under the beam of particles.
M25. The method according to the preceding embodiment, wherein the plurality of thermal elements comprises a connection between the stage and the sample holder.
M26. The method according to any of the preceding method embodiments and with the features of embodiments M9, and M23, wherein the at least one defined location comprises a location on the stage.
M27. The method according to any of the preceding method embodiments and with the features of embodiments M14, and M23, wherein the plurality of defined locations comprises a plurality of locations on the stage.
M28. The method according to any of the preceding method embodiments and with the features of embodiment M2, wherein the microscopy system is configured to be operated in an environment, and wherein an input to the thermal model comprises a temperature of the environment.
M29. The method according to any of the preceding method embodiments and with the features of embodiment M3, wherein the microscopy system comprises a vacuum chamber configured to house the sample, and wherein the plurality of thermal elements comprises the vacuum chamber.
M30. The method according to the preceding embodiment and with the features of embodiment M9, wherein the at least one defined location comprises a location in the vacuum chamber.
M31. The method according to the penultimate embodiment and with the features of embodiment M14, wherein the plurality of defined locations comprises a plurality of locations in the vacuum chamber.
M32. The method according to any of the preceding method embodiments and with the features of embodiment M23, wherein the microscopy system comprises at least one motor configured to drive the stage to position the sample under the beam of particles.
M33. The method according to the preceding embodiment, wherein the at least one motor comprises a plurality of motors, such as three motors, configured to drive the stage.
M34. The method according to any of the 2 preceding embodiments and with the features of embodiment M3, wherein the plurality of thermal elements comprises any of the at least one motor.
M35. The method according to any of the 3 preceding embodiments and with the features of embodiment M2, wherein an input to the thermal model comprises a power and/or voltage and/or current supplied to at least one motor.
M36. The method according to any of the 4 preceding embodiments, wherein a result of at least one motor driving the stage is dissipation of heat generated by the at least one motor.
M37. The method according to the preceding embodiment and with the features of embodiment M2, wherein an input to the thermal model comprises a magnitude and/or rate of heat dissipated by the at least one motor.
M38. The method according to any of the preceding method embodiments and with the features of embodiment M15, wherein the method comprises using the thermal model to predict the temperature measured by the at least one temperature sensor and comparing it with the input temperature measured by the at least one temperature sensor.
M39. The method according to the preceding embodiment, wherein the method further comprises updating the thermal model based on the difference between the predicted and input temperature corresponding to the at least one temperature sensor.
M40. The method according to any of the preceding method embodiments and with the features of embodiment M2, wherein the thermal model comprises a first sub-module configured to determine an expected temperature at a defined location in the microscopy system, and a second sub-module configured to determine the expected thermal drift of the sample.
M41. The method according to the preceding embodiment, wherein an input to the second sub-module is the expected temperature determined by the first sub-module.
M42. The method according to any of the 2 preceding embodiments and with the features of embodiment M9, wherein at least one of the at least one temperature sensor is configured to measure the temperature at a defined location significantly identical to the defined location for which the first sub-module is configured to determine the expected temperature.
M43. The method according to the preceding embodiment, wherein the method further comprises updating the first sub-module based on a difference between the temperature measured and the temperature determined by the first sub-module at the defined location.
M44. The method according to any of the 4 preceding embodiments and with the features of embodiment M35, wherein the power and/or voltage and/or current supplied to at least one motor are input to the first sub-module of the thermal model.
M45. The method according to any of the 4 preceding embodiments and with the features of embodiment M28, wherein the temperature of the environment is input to the first sub-module of the thermal model.
M46. The method according to any of the preceding method embodiments, wherein compensating for the drift of the sample and/or its image based on the expected thermal drift comprises controlling a position of the sample based on the expected thermal drift.
M47. The method according to any of the preceding method embodiments and with the features of embodiment M33, wherein the microscopy system comprises a control unit configured to position the sample by controlling the at least one motor.
M48. The method according to the preceding embodiment, wherein the control unit is configured to send data to the at least one motor.
M49. The method according to any of the 2 preceding embodiments, wherein the at least one motor is configured to receive data from the control unit, and based thereon, to position the sample.
M50. The method according to any of the preceding embodiments, wherein the microscopy system further comprises a position sensor configured to sense the position of the sample.
M51. The method according to the preceding embodiment and with the features of embodiment M47, wherein the position sensor is configured to send data relating to the sensed position of the sample to the control unit.
M52. The method according to the preceding embodiment, wherein the control unit is configured to receive data relating to the sensed position of the sample from the position sensor.
M53. The method according to the preceding embodiment, wherein the control unit is further configured to position the sample based on the sensed position of the sample and a target position.
M54. The method according to any of the preceding method embodiments, wherein the microscopy system further comprises an inverse kinematics module configured to at least receive data relating to a position in a first co-ordinate system.
M55. The method according to the preceding embodiment, wherein the inverse kinematics module is further configured to send data relating to a position in a second co-ordinate system, wherein the first co-ordinate system is not identical to the second co-ordinate system.
M56. The method according to any of the preceding embodiments and with the features of embodiment M54, wherein the input to the inverse kinematics module comprises the position of the sample as determined in the first co-ordinate system as a result of the expected thermal drift.
M57. The method according to any of the preceding embodiments and with the features of embodiments M23, and M55, wherein the output of the inverse kinematics module comprises data relating to a translation of the stage in the second co-ordinate system to compensate for the expected thermal drift of the sample.
M58. The method according to the preceding embodiment, wherein the method further comprises the inverse kinematics module sending the data relating to translation of the stage to the control unit.
M59. The method according to the preceding embodiment, wherein the control unit is configured for receiving the data relating to translation of the stage from the inverse kinematics module.
M60. The method according to any of the preceding method embodiments, wherein compensating for the drift of the sample and/or its image based on an expected thermal drift of the sample further comprises using an observed image of the sample as feedback to compensate for the drift of the sample and/or its image.
M61. The method according to the preceding embodiment, wherein the method comprises using an image processing module to compensate for the drift of the sample and/or its image.
M62. The method according to the preceding embodiment, wherein an input to the image processing module comprises an image of the sample.
M63. The method according to any of the 2 preceding embodiments, wherein an output of the image processing module comprises data relating to an observed position of the sample.
M64. The method according to the preceding embodiment and with the features of embodiment M56, wherein an input to the inverse kinematics module further comprises data relating to the observed position of the sample.
M65. The method according to the preceding embodiment and with the features of embodiment M57, wherein the data relating to a translation of the stage is based on the difference between the expected thermal drift of the sample and the observed drift of the sample.
M66. The method according to any of the preceding method embodiments and with the features of embodiment M5, wherein the artificial-intelligence based model comprises any of an artificial neural network, a random forest, a Gaussian process, a hidden Markov model, a state vector machine, or any other artificial intelligence model.
M67. The method according to the preceding embodiment, wherein the expected thermal drift is determined by the artificial intelligence-based model using, at least in part, supervised learning.
M68. The method according to any of the preceding method embodiments and with the features of embodiment M5, wherein an output of the artificial intelligence-based model comprises the expected thermal drift of the sample and/or its image.
M69. The method according to any of the preceding method embodiments and with the features of embodiments M5, and M9, wherein an input to the artificial intelligence-based model comprises the temperature measured by at least one of the at least one temperature sensors.
M70. The method according to any of the preceding method embodiments and with the features of embodiments M5, and M35, wherein an input to the artificial intelligence-based model comprises a power and/or voltage and/or current supplied to at least one motor.
M71. The method according to any of the preceding method embodiments and with the features of embodiment M2, wherein an input to the thermal model comprises data relating to humidity.
   For example, such data may comprise the relative humidity of the microscopy system's environment, or the humidity around any of the thermal elements described above.
M72. The method according to any of the preceding method embodiments, wherein the method is implemented, at least in part, on a data processing unit.

Below system embodiments will be discussed. These are abbreviated by the letter 'S' followed by a number. Whenever reference is herein made to system embodiments, these embodiments are meant.
S1. A microscopy system comprising a sample, wherein the microscopy system is configured to reduce drift of the sample and/or its image by
   determining an expected thermal drift of the sample, and
   compensating for the drift of the sample and/or its image based upon the expected thermal drift.
S2. The microscopy system according to the preceding embodiment, wherein the expected thermal drift is determined, at least in part, by means of a thermal model configured to at least receive some input and produce some output.
S3. The microscopy system according to the preceding embodiment, wherein the microscopy system comprises a plurality of thermal elements configured for heat transfer and/or heat exchange, and wherein the thermal model is based, at least in part, on the heat flow through and/or between any of the plurality of thermal elements.
S4. The microscopy system according to any of the preceding system embodiments, wherein the expected thermal drift is determined, at least in part, by means of an artificial intelligence-based model.
S5. The microscopy system according to any of the preceding system embodiments and with the features of embodiment S3, wherein the plurality of thermal elements comprises a sample holder configured to hold the sample.
S6. The microscopy system according to any of the preceding system embodiments, wherein the microscopy system comprises at least one temperature sensor configured to measure the temperature of at least one defined location in the microscopy system.
S7. The microscopy system according to the preceding embodiment, wherein the at least one temperature sensor comprises a plurality of temperature sensors configured to measure the temperature at a plurality of defined locations in the microscopy system.
S8. The microscopy system according to any of the preceding system embodiments, wherein the microscopy system is configured to direct a beam of particles at the sample.
S9. The microscopy system according to the preceding embodiment, wherein the beam of particles comprises charged particles.
S10. The microscopy system according to any of the 2 preceding embodiments and with the features of embodiment S3, wherein the plurality of thermal elements comprises a stage configured to position the sample under the beam of particles.
S11. The microscopy system according to any of the preceding system embodiments and with the features of embodiment S3, wherein the microscopy system comprises a vacuum chamber configured to house the sample, and wherein the plurality of thermal elements comprises the vacuum chamber.
S12. The microscopy system according to any of the preceding system embodiments and with the features of embodiment S10, wherein the microscopy system comprises at least one motor configured to drive the stage to position the sample under the beam of particles.
S13. The microscopy system according to the preceding embodiment, wherein the microscopy system comprises a control unit configured to position the sample by controlling the at least one motor.
S14. The microscopy system according to any of the preceding system embodiments, wherein the microscopy system comprises a position sensor configured to sense a position of the sample.
S15. The microscopy system according to any of the preceding system embodiments, wherein the microscopy system comprises a data processing unit configured to determine the expected thermal drift.
S16. The microscopy system according to the preceding embodiment and with the features of embodiment S2, wherein the thermal model is configured to be run on the data processing unit.
S17. The microscopy system according to any of the 2 preceding embodiments and with the features of embodiment S4, wherein the artificial intelligence-based model is configured to be run on the data processing unit.
S18. The microscopy system according to any of the preceding system embodiments and with the features of embodiments S13, and S15, wherein the data processing unit is configured to send data to the control unit.
S19. The microscopy system according to the preceding embodiment, wherein the control unit is configured to receive data from the data processing unit.
S20. The microscopy system according to any of the preceding system embodiments, wherein the microscopy system is configured to perform the method according to any of the preceding method embodiments.

Below computer program product embodiments will be discussed. These are abbreviated by the letter'P' followed by a number. Whenever reference is herein made to computer program product embodiments, these embodiments are meant.

P1. A computer program product comprising instructions, when run on a data processing unit of a microscopy system according to any of the preceding system and embodiments and with the features of embodiment S15, to perform the method according to any of the preceding method embodiments.

### Brief description of drawings

Embodiments of the present technology will now be discussed with reference to the accompanying figures. For the sake of clarity, some features may only be shown in some figures, and others may be omitted. However, also the omitted features may be present, and the depicted and discussed features do not need to be present in all embodiments.
- Figure 1: depicts a microscopy system;
- Figure 2a: depicts a stage assembly of the microscopic system;
- Figure 2b: depicts perspective view of an actuation mechanism of the stage assembly;
- Figure 2c: depicts a top view of the actuation mechanism;
- Figure 2d: depicts a schematic of a thermal model for a part of the microscopy system;
- Figure 3: depicts an exemplary method to correct for thermal drift;
- Figure 4: depicts another exemplary method to correct for thermal drift; and
- Figure 5: depicts yet another exemplary method to correct for thermal drift.

### Detailed description of drawings

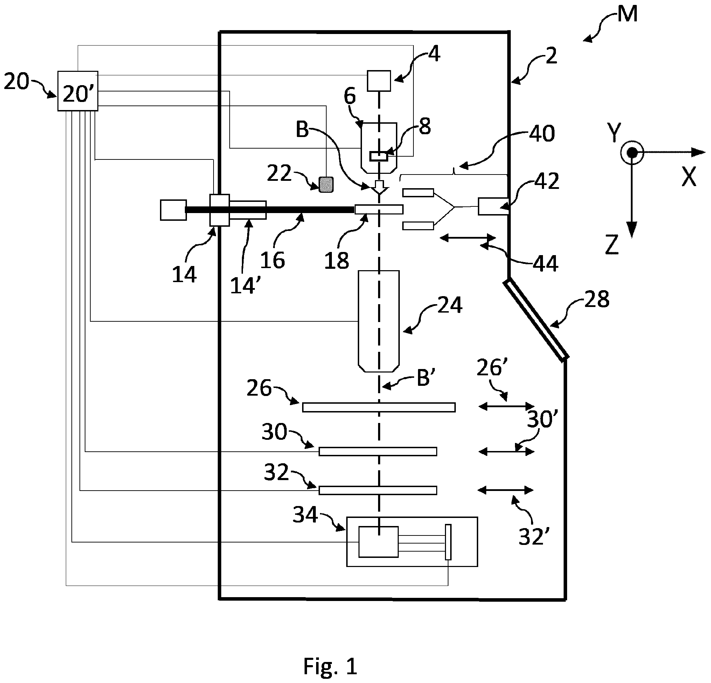

Figure 1 depicts an embodiment of a microscopy system M, particularly a charged particle microscopy system M configured to use a charged particle beam B to observe and/or characterize a sample 18. The charged particle beam B may comprise electrons or ions. In the particular case depicted in Fig. 1, it comprises electrons. Additionally, the microscopy system M depicted in Fig. 1 may comprise a transmission-type microscopy system M, wherein an image of the sample 18 is taken using the emissions in the transmission region of the microscopy system M. Thus, M may represent a Transmission Electron Microscope (TEM) or a Scanning Transmission Electron Microscope (STEM). In the Figure, within a vacuum enclosure 2, an electron source 4 produces the beam B of electrons that propagates along an electron-optical axis B' and traverses an electron-optical illuminator 6, serving to direct/focus the electrons onto a chosen part of the sample 18 (which may, for example, be (locally) thinned/planarized).

Also depicted is a deflector 8, which (inter alia) can be used to effect scanning motion of the beam B. The sample 18 may be held on a sample holder 16 that can be positioned in multiple degrees of freedom by a positioning device/stage 14, which moves a cradle 14' into which holder 16 is (removably) affixed; for example, the sample holder 16 may comprise a finger that can be moved (inter alia) in the XY plane (see the depicted Cartesian coordinate system; typically, motion parallel to Z and tilt about X/Y will also be possible). Such movement allows different parts of the sample 18 to be illuminated / imaged / inspected by the electron beam B traveling along axis B' (in the Z direction) (and/or allows scanning motion to be performed, as an alternative to beam scanning). If desired, an optional cooling device (not depicted) can be brought into intimate thermal contact with the sample holder 16, so as to maintain it (and the sample 18 thereupon) at cryogenic temperatures, for example.

The electron beam B will interact with the sample 18 in such a manner as to cause various types of "stimulated" radiation to emanate from the sample 18, including (for example) secondary electrons, backscattered electrons, X-rays and optical radiation (cathodoluminescence). If desired, one or more of these radiation types can be detected with the aid of analysis device 22, which might be a combined scintillator/photomultiplier or EDX (Energy-Dispersive X-Ray Spectroscopy) module, for instance; in such a case, an image could be constructed using basically the same principle as in a Scanning Electron Microscope (SEM). However, alternatively or supplementally, one can study electrons that traverse (pass through) the sample 18, exit/emanate from it and continue to propagate (substantially, though generally with some deflection/scattering) along axis B'.

Such a transmitted electron flux enters an imaging system (projection lens) 24, which will generally comprise a variety of electrostatic / magnetic lenses, deflectors, correctors (such as stigmators), etc. In normal (non-scanning) TEM mode, this imaging system 24 can focus the transmitted electron flux. One may make use of the fact that the depth of focus of the electron flux leaving imaging system 24 is generally quite large (e.g. of the order of 1 meter). Consequently, various types of analysis apparatus can be used downstream of imaging system 24, such as a TEM camera 30. At camera 30, the electron flux can form a static image (or diffractogram) that can be processed by controller/processor 20 and displayed on a display device (not depicted), such as a flat panel display, for example. When not required, camera 30 can be retracted/withdrawn (as schematically indicated by arrows 30') so as to get it out of the way of axis B'. Alternatively, or additionally, the imaging system 24 may be used to focus the transmitted electron flux onto a fluorescent screen 26, which, if desired, can be retracted/withdrawn (as schematically indicated by arrows 26') so as to get it out of the way of axis B'. An image (or diffractogram) of (part of) the sample 18 will be formed by imaging system 24 on screen 26, and this may be viewed through viewing port 28 located in a suitable part of a wall of enclosure 2. The retraction mechanism for screen 26 may, for example, be mechanical and/or electrical in nature, and is not depicted here.

The analysis apparatus may further comprise a STEM camera 32. An output from camera 32 can be recorded as a function of (X,Y) scanning position of the beam B on the sample 18, and an image can be constructed that is a "map" of output from camera 32 as a function of X,Y. Camera 32 can comprise a single pixel with a diameter of e.g. 20 mm, as opposed to the matrix of pixels characteristically present in camera 30. Moreover, camera 32 will generally have a much higher acquisition rate (e.g., 10⁶ points per second) than camera 30 (e.g., 10² - 10³ images per second). Once again, when not required, camera 32 can be retracted/withdrawn (as schematically indicated by arrows 32') so as to get it out of the way of axis B' (although such retraction would not be a necessity in the case of a donut-shaped annular dark field camera 32, for example; in such a camera, a central hole would allow flux passage when the camera was not in use).

As an alternative to imaging using cameras 30 or 32, one can also invoke spectroscopic apparatus 34, which could be an EELS module, for example. It should be noted that the order/location of items 30, 32 and 34 is not strict, and many possible variations are conceivable. For example, spectroscopic apparatus 34 can also be integrated into the imaging system 24. Note that the controller (computer processor) 20 is connected to various illustrated components via control lines (buses) 20'. This controller 20 can provide a variety of functions, such as synchronizing actions, providing setpoints, processing signals, performing calculations, and displaying messages/information on a display device (not depicted). Needless to say, the (schematically depicted) controller 20 may be (partially) inside or outside the enclosure 2, and may have a unitary or composite structure, as desired. The skilled artisan will understand that the interior of the enclosure 2 does not have to be kept at a strict vacuum; for example, in a so-called "Environmental TEM/STEM", a background atmosphere of a given gas is deliberately introduced / maintained within the enclosure 2. The skilled artisan will also understand that, in practice, it may be advantageous to confine the volume of enclosure 2 so that, where possible, it essentially hugs the axis B', taking the form of a small tube (e.g., of the order of 1 cm in diameter) through which the employed electron beam passes, but widening out to accommodate structures such as the source 4, sample holder 16, screen 26, camera 30, camera 32, spectroscopic apparatus 34, etc.

The microscope M may further comprise a retractable X-ray CT module 40, which can be advanced/withdrawn with the aid of positioning system 42 so as to place it on / remove it from the path of the beam B (see arrow 44). In the particular configuration illustrated here, the module 40 comprises a fork-like frame on which are mounted - a target above the plane of the sample 18, and an X-ray detector below the plane of the sample 18.

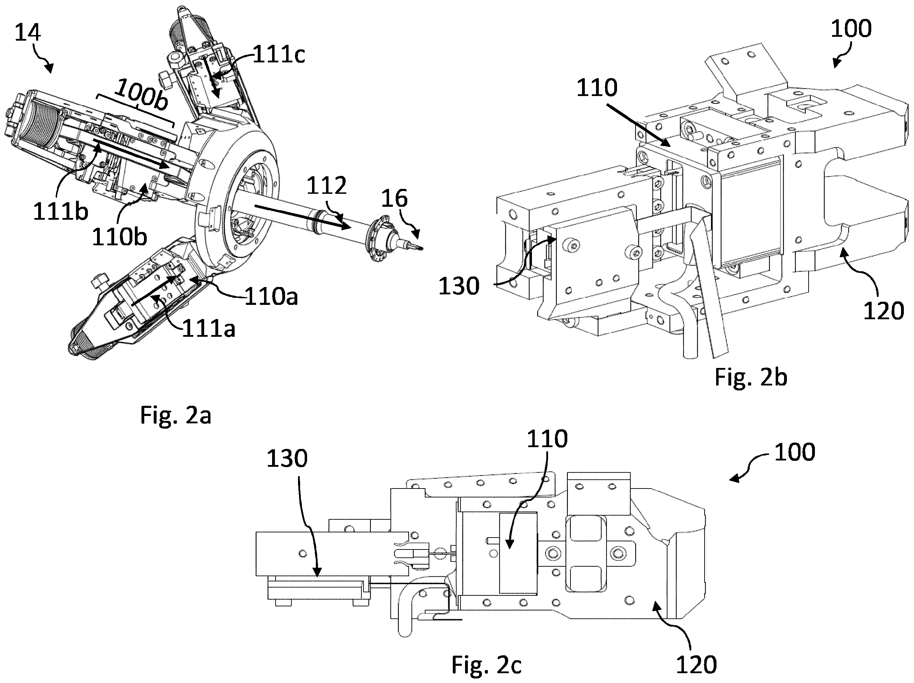

Figures 2a to 2c depict an exemplary stage assembly 14 and its various components for the microscopy system M. The stage assembly 14 may comprise means to allow positioning and/or orienting of the sample holder 16.

Upon insertion into a column 2 of the microscopy system M, the sample holder 16 may experience thermal drift owing to potential temperature differences between the ambient sample holder temperature and the column temperature. Further, thermal drift may arise from heat dissipation effects in the stage assembly 14. These are further described below.

In the example depicted in Figure 2a, the stage assembly 14 comprises a plurality of arms, each comprising an actuation mechanism 100, such as the actuation mechanism 100b (the actuation mechanisms 100a, and 100c are not depicted), the plurality of arms comprising motors 110, viz., three motors 110a, 110b, 110c (not marked), each of which is configured to effect a translation in a direction depicted by arrow 111a for motor 110a. It will be understood that motors 110b, and 110c (not marked) may also be configured to provide a translational motion in corresponding directions 111b, and 111c. The plurality of motors 110 may be arranged such that a result of the translation in each of the directions 111a, 111b, 111c may result in a translation of the sample holder 16 in a direction depicted by the arrow 112. More particularly, translation by defined distances in each of the directions 111a, 111b, 111c may result in a translation of the sample holder 16 in a defined direction by a defined distance, wherein the translation of the sample holder 16 is related to the translation by each of the defined distances in the directions 111a, 111b, 111c. The microscopy system may comprise, for example, a data processing unit that may comprise an inverse kinematics module that may be used to go between translations (distance and direction) of the sample holder and translations (distances along the directions 111) effected by the motors 110.

Figure 2b depicts a zoom-in of one of the arms (for example, the arm labelled 'b' in Figure 2a) of the stage assembly 14, and particularly the actuation mechanism 100 (for example, the actuation mechanism labelled 100b in Figure 2a) of the stage assembly 14. The actuation mechanism 100 comprises the motor 110 that may be a piezomotor, for example. The motor 110 may be enclosed in a housing 120 that may comprise a heat conducting material, e.g., aluminum. The actuation mechanism 100 may further comprise a position sensor (that may also be called an encoder) 130 configured to detect a position of the sample holder. As depicted in Figure 2c, the position sensor 130 may be in thermal contact with the housing 120. In a typical operation, the position sensor 130 may measure the position of the sample holder 16 and feed it back to the motor 110 (or preferably a controller of the motor 110), wherein the motor 110 may be operated so as to reduce the difference between the position of the sample holder 16 as sensed by the position sensor 130 and a target sample holder position.

Operation of the motor 110 to effect a translation of the sample holder 16 as described above may result in generation of heat inside the motor 110. At least a part of this heat may be transferred to the housing 120. This may cause the housing 120 to expand, in turn pushing a head of the position sensor 130. Thus, the position sensor 130 may register a position different from the intended position and may cause the motor 110 to re-position the sample holder 16 based on the position registered by position sensor 130 after the position sensor 130 has thermally drifted. This may then lead to an image drift of the sample 18 as well.

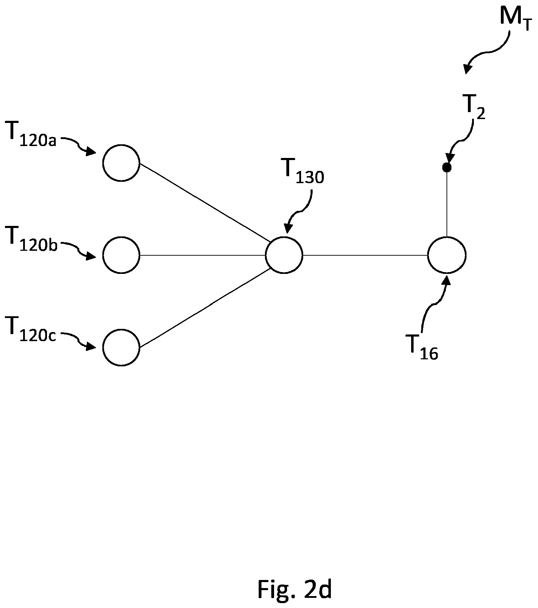

A schematic M_{T} of the heat flow through a small part of the microscopy system M is depicted in Figure 2d. It depicts the housings 120a, 120b, and 120c of the three arms of the stage assembly 14 at temperatures T₁₂₀ₐ, T_{120b}, and T_{120c}, respectively. They are in thermal contact with the position sensor 130 at temperature T₁₃₀. The position sensor 130 may exchange heat with the sample holder 16 that may be at temperature T₁₆. The sample holder 16 may, among other channels, also exchange heat with the vacuum chamber 2 at temperature T₂. Thus, a model of thermal exchanges between different thermal elements may be realized that may be used to determine an expected thermal drift of the sample 18. Furthermore, as may be appreciated, Figure 2d depicts only a representative schematic of such a model and embodiments of the present invention may also include more detailed models for heat exchange with more thermal elements and possibly different modes of heat exchange between thermal elements (including, for example, thermal conduction, thermal radiation, and/or thermal convection).

The present technology is directed to correcting for thermal drift as described above. Embodiments of the present technology relate to the use of a model to determine the expected thermal drift of the sample holder 16 and correcting for it. The model may accept some input and produce some output. The output may comprise the expected thermal drift of the sample holder 16. Different embodiments will now be described in greater detail with reference to the remaining figures.

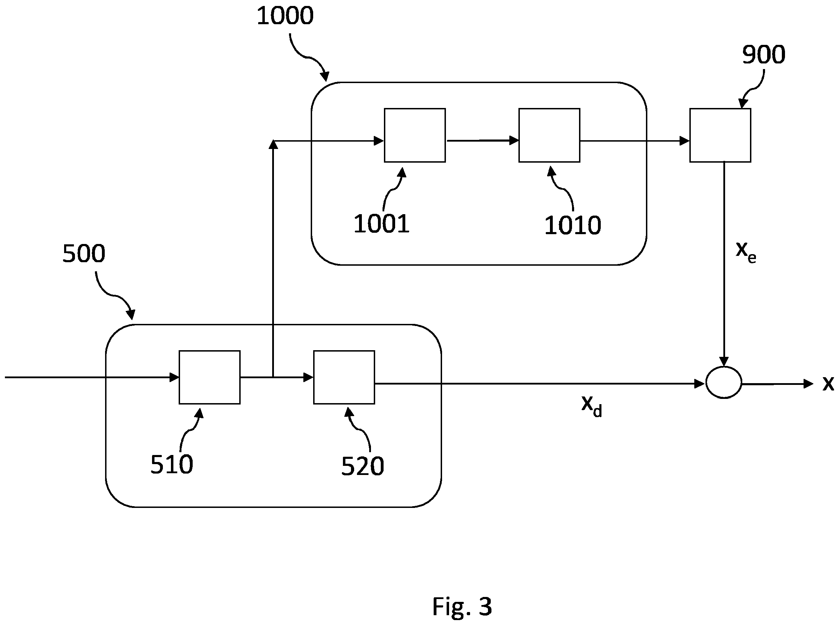

Figure 3 depicts a first embodiment of the present invention. Box 500 depicts the effects of dissipation of heat that may be generated by the motors 110 as described above. Heat (depicted as the arrow going into the sub-box 510) may raise the temperature of the sample holder 16 (the temperature of the sample holder 16 is depicted by the arrow leaving sub-box 510) which may then lead to a thermal drift of the sample holder 16 leading to a final position, x_{d}, (depicted as the arrow leaving sub-box 520). As further depicted, the model 1000 comprises a sub-module 1001 configured to determine the expected thermal drift. The sub-module 1001 is configured to accept an input parameter that may comprise the value of a defined property at a defined location. For example, the defined property may be a temperature at a defined location in the microscopy system. The defined location may comprise, for example, a location on the sample holder 16. The microscopy system M may comprise a means to measure the defined property at the defined location. For example, it may comprise a temperature sensor to measure the temperature at the defined location on the sample holder 16. The sub-module 1001 may be configured to determine the expected thermal drift based on the input parameter. For example, in case the input parameter is a temperature of the sample holder 16, the sub-module 1001 may determine the expected thermal drift based on the coefficient of thermal expansion of the sample holder 16.

Alternatively, if the input parameter comprises temperature measured at another location in the microscopy system M, the sub-module 1001 may comprise a model for heat transfer through, and/or heat exchange between, different components of the microscopy system M (that may be called thermal elements) such that a resulting thermal drift of the sample holder 16 may be determined based on the measured temperature at the defined location. For example, the defined location may comprise a location on the position sensor 130 as depicted in Figure 1. The sub-module 1001 may then comprise a model for heat flow from the position sensor 130 to the sample holder 16, and from the position sensor 130 to the housing 120, among other possible heat flows from the position sensor 130.

A plurality of temperature sensors may be used and the input to the sub-module 1001 may comprise a difference of at least one pair of temperatures measured by the plurality of temperature sensors. This may be more robust than providing a single measured temperature as any noise in the measurement of temperature may be eliminated in the difference of temperatures. The sub-module 1001 may determine the expected thermal drift based on thermal properties of the thermal elements comprising any of a thermal conductivity, coefficient of thermal expansion, rate of heat flow, thermal emissivity, surface area, and temperature, among others.

The expected thermal drift output from the sub-module 1001 may then be converted to a translation to be applied by any of the motors 110 depicted in Figure 1. This may be achieved via an inverse kinematics module 1010. The inverse kinematics module 1010 may be configured to accept data relating to position in a first co-ordinate system and to send data relating to position in a second co-ordinate system. The expected thermal drift from the sub-module 1001, and more precisely the inverse of the expected thermal drift from the sub-module 1001, may be sent to the inverse kinematics module 1010 which may then determine the translation to be applied to any of the motors 110 to compensate for the expected thermal drift. This translation may be fed into the sub-module 900 which may carry out the translation of any of the motors 110. A result of the translation may be a translation vector, xₑ, that may be subtracted from the position of the sample holder 16 owing to the thermal drift, x_{d}. Thus, the resulting thermal drift of the sample holder 16, and thus the sample 18, may be reduced. This embodiment may be referred to as a feedforward control of thermal drift as the expected thermal drift is already compensated for before the actuation of the sample holder 16.

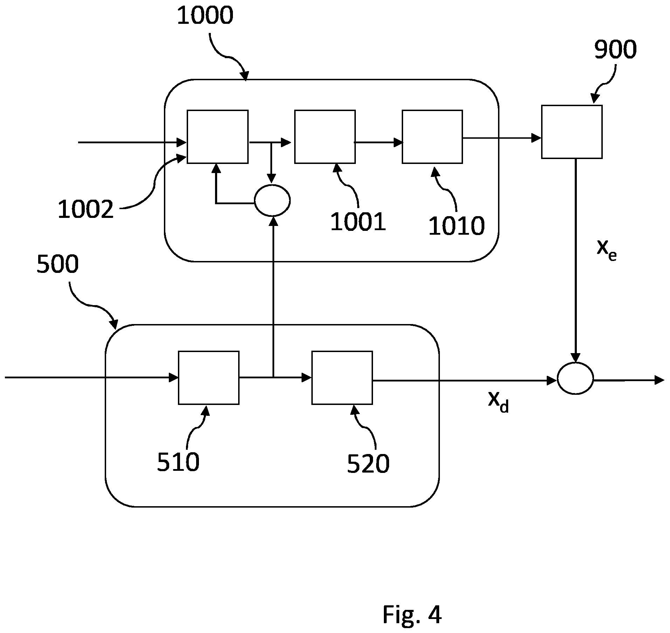

A second embodiment of the present invention is depicted in Figure 4. This embodiment builds on the embodiment depicted in Figure 3. As depicted in Figure 4, the model 1000 comprises a further sub-module 1002 to determine the expected thermal drift. Sub-module 1002 is configured to accept an input parameter that may comprise, for example, a current/power signal supplied to the motor 110, a temperature of the sample holder 16 prior to insertion into the microscope column 2, or an ambient temperature. The sub-module 1002 may be further configured to determine an expected value of a defined property at a defined location in the microscopy system M. The defined property may comprise a temperature and the defined location may correspond to a location on the sample holder 16, for example. To determine the expected value, the sub-module 1002 may also comprise a model for heat transfer through, and/or heat exchange between, different components of the microscope system M as described above for sub-module 1001.

The microscopy system M may be further configured to measure the defined property at the defined location. An appropriate sensor may be provided for this purpose. For the example described above a temperature sensor may be provided for measuring temperature at the defined location on the sample holder 16. The measured value of the defined property may then be fed back to the model 1000 and the model 1000 may be configured to compare the measured value of the defined property to the expected value determined from the sub-module 1002. Based on this comparison, the model 1000, and more particularly, the sub-module 1002 of the model 1000, may be updated such that the value determined by the sub-module 1002 is substantially identical to the value measured. Thus, the sub-module 1002 may be calibrated to determine a substantially accurate value of the defined property.

The determined value of the defined property is then sent as an input to the sub-module 1001 that may be substantially identical to the sub-module 1001 as depicted in Figure 3. As described above, based on this input value the sub-module 1001 may be configured to determine the expected thermal drift and via the inverse kinematics module 1010 effect a compensatory translation of the sample holder 16, and thus the sample 18.

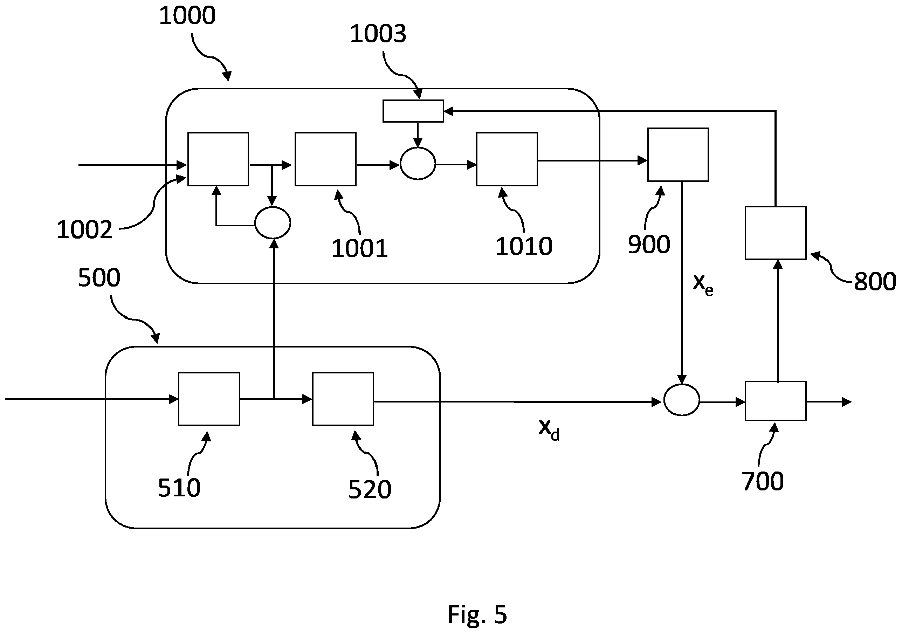

A further embodiment of the model 1000 is depicted in Figure 5. As before, this embodiment also builds on the embodiment depicted in Figure 4. It will be understood, however, that these embodiments are merely exemplary and the embodiment depicted in Figure 5 may, for example, build directly on the embodiment depicted in Figure 3 without the features depicted in Figure 4.

The model 1000 may further comprise a sub-module 1003. The sub-module 1003 may be configured to accept the measured position of the sample 18 from an image processing module 800. The image processing module 800 may be configured to convert the image of the sample 18, as captured by some optics and cameras 700 of the microscopy system M, from pixel space to position space. The measured position may also be fed back into the model 1000, more particularly, to the output of sub-module 1002. Based on the difference of the measured position and the expected position of the sample 18 owing to the expected thermal drift the inverse kinematics module 1010 may then be configured to determine the translation of the motors 110. Thus, this configuration may allow a real-time feedback loop that may be of further advantage in reducing the thermal drift.

While the model 1000 described above comprises a physical model, alternative embodiments may comprise an artificial-intelligence based model. Such a model 1000 may accept as an input a defined property at a defined location of the microscopy system M such as a temperature at a location on the sample holder 16, an ambient temperature, or even a current/power signal supplied to the motor 110. The model 1000 may then be configured to output an expected thermal drift of the sample 18. The model 1000 may comprise any of an artificial neural network, a random forest, a gradient boosting machine, and a support vector machine, among others. It may be trained based on the data collected using the method as described above. Or it may comprise a model based on unsupervised learning.

In addition, while the above description has focused on using temperature as the measured property, it will be understood that this is only exemplary and any other suitable physical property may also be measured and used as described above for temperature to determine the expected thermal drift without deviating from the present invention.

Overall, embodiments of the present technology thus provide a method, a corresponding system, and a computer program product to correct for the thermal drift of a sample and/or its image in a microscopy system that may improve the efficiency and robustness of the imaging process.

Whenever a relative term, such as "about", "substantially" or "approximately" is used in this specification, such a term should also be construed to also include the exact term. That is, e.g., "substantially straight" should be construed to also include "(exactly) straight".

Whenever steps were recited in the above or also in the appended claims, it should be noted that the order in which the steps are recited in this text may be accidental. That is, unless otherwise specified or unless clear to the skilled person, the order in which steps are recited may be accidental. That is, when the present document states, e.g., that a method comprises steps (A) and (B), this does not necessarily mean that step (A) precedes step (B), but it is also possible that step (A) is performed (at least partly) simultaneously with step (B) or that step (B) precedes step (A). Furthermore, when a step (X) is said to precede another step (Z), this does not imply that there is no step between steps (X) and (Z). That is, step (X) preceding step (Z) encompasses the situation that step (X) is performed directly before step (Z), but also the situation that (X) is performed before one or more steps (Y1), ..., followed by step (Z). Corresponding considerations apply when terms like "after" or "before" are used.

While in the above, a preferred embodiment has been described with reference to the accompanying drawings, the skilled person will understand that this embodiment was provided for illustrative purpose only and should by no means be construed to limit the scope of the present invention, which is defined by the claims.

## Claims

1. A method to reduce drift of a sample and/or its image in a microscopy system, wherein the method comprises
determining an expected thermal drift of the sample, and
compensating for the drift of the sample and/or its image based upon the expected thermal drift.

2. The method according to the preceding claim, wherein the expected thermal drift is determined, at least in part, by means of a thermal model configured to at least receive some input and produce some output.

3. The method according to the preceding claim, wherein the microscopy system comprises a plurality of thermal elements configured for heat transfer and/or heat exchange, and wherein the thermal model is based, at least in part, on the heat flow through, and/or between, any of the plurality of thermal elements.

4. The method according to the preceding claim, wherein the plurality of thermal elements comprises a sample holder configured to hold the sample.

5. The method according to claim 1, wherein the microscopy system comprises at least one property sensor configured to measure at least one defined property of at least one defined location in the microscopy system.

6. The method according to any of the preceding claim and with the features of claim 2, wherein an input to the thermal model comprises the at least one defined property.

7. The method according to any of the 2 preceding claims, wherein the at least one defined property comprises a temperature and the at least one property sensor comprises a temperature sensor.

8. The method according to any of the 2 preceding claims and with the features of claim 2, wherein an input to the thermal model comprises a temperature measured by at least one temperature sensor.

9. The method according to any of the preceding claims and with the features of claims 4, and 5, wherein the at least one defined location comprises a location on the sample holder.

10. The method according to any of the preceding claims, wherein the method is implemented, at least in part, on a data processing unit.

11. A microscopy system comprising a sample, wherein the microscopy system is configured to reduce drift of the sample and/or its image by
determining an expected thermal drift of the sample, and
compensating for the drift of the sample and/or its image based upon the expected thermal drift.

12. The microscopy system according to the preceding claim, wherein the microscopy system is configured to direct a beam of particles at the sample, wherein the beam of particles comprises charged particles.

13. The microscopy system according to any of the 2 preceding claims, wherein the microscopy system comprises a data processing unit configured to determine the expected thermal drift.

14. A computer program product comprising instructions, when run on a data processing unit of a microscopy system according to claim 13, to perform the method according to any of the claims 1 to 10.
